(19) **Europäisches Patentamt / European Patent Office / Office européen des brevets**

(11) **EP 3 373 304 A2**

(12) **EUROPEAN PATENT APPLICATION**

(43) Date of publication:
**12.09.2018 Bulletin 2018/37**

(51) Int Cl.:
**G11C 11/54** (2006.01)    **G11C 11/16** (2006.01)
**G11C 13/00** (2006.01)    **H03K 19/168** (2006.01)
**G06N 3/063** (2006.01)    **G06N 3/04** (2006.01)

(21) Application number: **17202762.5**

(22) Date of filing: **21.11.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.11.2016 EP 16199877**

(71) Applicants:
• **IMEC vzw**
  **3001 Leuven (BE)**
• **Katholieke Universiteit Leuven**
  **3000 Leuven (BE)**

(72) Inventors:
• **GARBIN, Daniele**
  **3001 Leuven (BE)**
• **RODOPOULOS, Dimitrios**
  **3001 Leuven (BE)**
• **DEBACKER, Peter**
  **3001 Leuven (BE)**
• **RAGHAVAN, Praveen**
  **3001 Leuven (BE)**

(74) Representative: **DenK iP**
  **Hundelgemsesteenweg 1116**
  **9820 Merelbeke (BE)**

(54) **SEMICONDUCTOR CELL FOR PERFORMING A LOGIC XNOR OR XOR OPERATION**

(57) A semiconductor cell (100, 400) for performing a logic XNOR or XOR operation, the semiconductor cell (100, 400) comprising a memory unit (101, 401) for storing a first operand, an input port unit (102, 402) for receiving a second operand, a switch unit (103 403) configured for implementing the logic XNOR or XOR operation on the stored first operand and the received second operand, and a readout port (104, 404) for providing an output of the logic operation. A plurality of cells may be organized in an array, and one or more of such arrays may be used for implementing a neural network.

FIG. 2

EP 3 373 304 A2

**Description**

**Field of the invention**

The present invention relates to the field or integrated machine learning, namely the semiconductor integration of basic machine learning kernels. In particular, the present invention relates to a semiconductor cell for performing an XNOR or XOR operation between a first and a second operand, to an array of such semiconductor cells, to a set comprising a plurality of such arrays, and to a method of using at least one array of semiconductor cells for the implementation of a neural network.

**Background of the invention**

Neural networks (NNs) are classification techniques used in the machine learning domain. Typical examples of such classifiers include Multi-Layer Perceptrons (MLPs) or Convolutional Neural Network (CNNs).

Neural network (NN) architectures comprise layers of "neurons" (which are basically multiply-accumulate units), weights that interconnect them and particular layers, used for various operations, among which normalization or pooling. As such, the algorithmic foundations for these machine learning objects have been established at length in prior art.

The computation involved in training or running these classifiers has been facilitated using Graphics Processing Units (GPUs) or custom Application-Specific Integrated Circuits (ASICs), for which dedicated software flows have been extensively developed.

Many software approaches have advocated the use of NNs (either MLPs or CNNs) with binary weights and activations, showing minimal accuracy degradation of state-of-the-art classification benchmarks. The goal of such approaches is to enable neural network GPU kernels of smaller memory footprint and higher performance, given that the data structures exchanged from/to the GPU are aggressively reduced. However, none of the known approaches can overcome the high energy that is involved for each classification run on a GPU, especially the leakage energy component related solely to the storage of the NN weights. A benefit of assuming weights and activations of two possible values each (either +1 or -1) is that the multiply-accumulate operation (i.e. dot-product) that is typically encountered in NNs boils down to a popcount of element-wise XNOR or XOR operations.

A dot-product or scalar product is an algebraic operation that takes two equal-length sequences of numbers and returns a single number. A dot-product is very frequently used as a basic mathematical NN operation. At least at the inference phase (i.e. not during training), a wide range of machine learning implementations (e.g. MLPs or CNNs) can be decomposed to layers of dot-product operators, interleaved with simple arithmetic operations. Most of these implementations pertain to the classification of raw data (e.g. the assignment of a label to a raw data frame).

Dot-product operations are typically performed between values that depend on the NN input (e.g. a frame to be classified) and constant operands. The input-dependent operands are sometimes referred to as "activations". For the case of MLPs, the constant operands are the weights that interconnect two MLP layers. For the case of CNNs, the constant operands are the filters that are convolved with the input activations or the weights of the final fully connected layer. A similar thing can be said for the simple arithmetic operations that are interleaved with the dot-products in the classifier: for example, normalization is a mathematical operation between the outputs of a hidden layer and constant terms that are fixed after training of the classifier.

**Summary of the invention**

It is an object of the present invention to reduce energy requirements of classification operations.

The above objective is accomplished by a semiconductor cell, an array of semiconductor cells and a method of using at least one array of semiconductor cells, according to embodiments of the present invention.

In a first aspect, the present invention provides a semiconductor cell for performing a logic XNOR or XOR operation. the semiconductor cell comprises:

- a memory unit for storing a first operand,
- an input port unit for receiving a second operand,
- a switch unit configured for implementing the logic XNOR or XOR operation on the stored first operand and the received second operand, and
- a readout port (104, 404) for providing an output of the logic operation.

In a semiconductor cell according to embodiments of the present invention, the switch unit may be arranged for being provided with both the stored first operand and a complement of the stored first operand and further with the received second operand and a complement of the received second operand to perform the logic operation. In such embodiments, the memory unit may comprise a first memory element and a second memory element, for storing the first operand and for storing the complement of the first operand, respectively.

In a semiconductor cell according to embodiments of the present invention, the switch unit may comprise a first switch and a second switch for being controlled by the received second operand and the complement of the received second operand, respectively. Furthermore, each of the stored first operand and the complement of the stored first operand may be switchably connected through one of the first or second switch to a common node that is coupled to the readout port.

In a semiconductor cell according to embodiments of the present invention, the memory unit may be a non-volatile memory unit. In particular embodiments, the non-volatile memory unit may comprise non-volatile memory elements supporting multi-level readout.

In a semiconductor cell according to embodiments of the present invention, the switch unit may be implemented using vertical transistors, i.e. transistors which have a channel perpendicular to the wafer substrate, such as e.g. vFETs, vertical nanowires, vertical nanosheets, etc..

In a second aspect, the present invention provides an array of cells logically organized in rows and columns, wherein the cells are semiconductor cells according to embodiments of the first aspect of the present invention.

In embodiments of the present invention, the array may furthermore comprise word lines and read bit lines, wherein the word lines are configured for delivering second operands to input ports of the semiconductor cells, and wherein the read bit lines are configured for receiving the outputs of the XNOR or XOR operations from the readout ports of the cells in the array connected to that read bit line.

An array according to embodiments of the present invention may furthermore comprise a sensing unit shared between different cells of the array, for instance a sensing unit shared between different cells of a column of the array, such as between all cells of a column of the array.

An array according to embodiments of the present invention may furthermore comprise a pre-processing unit for creating the second operand for at least one of the semiconductor cells in the array, e.g. for receiving a signal, and for creating therefrom the second operand.

In embodiments of the present invention, the readout port of at least one semiconductor cell from at least one row and at least one column of the array may be read by at least one sensing unit configured to distinguish between at least two levels of a readout signal at the readout port of the at least one read semiconductor cell. The distinguishing between a plurality of levels of the readout signal may for instance be done by comparing the level of the readout signal with a plurality of reference signals.

An array according to embodiments of the present invention may furthermore comprise at least one post-processing unit, for implementing at least one logical operation on at least one value read out of the array.

An array according to embodiments of the present invention may, furthermore comprise allocation units for allocating subsets of the array to nodes of a directed graph.

In a third aspect, the present invention provides a set comprising a plurality of arrays according to embodiments of the second aspect, wherein the arrays are connected to one another in a directed graph. The arrays form the nodes of the directed graph.

In a set according to embodiments of the present invention, the arrays may be statically connected according to a directed graph. Alternatively, the arrays may be dynamically reconfigurable, in which cans the set may furthermore comprise intermediate routing units for reconfiguring connectivity between the arrays in the directed graph.

In a fourth aspect, the present invention provides a 3D-array comprising at least two arrays according to any embodiments of the present invention, wherein the semiconductor cells of respective arrays are physically stacked in layers one on top of the other. Different ways of stacking are possible, such as for example wafer stacking, monolithic processing of transistors on the same wafer, provision of an interposer, etc.

In a fifth aspect, the present invention provides a method of using at least one array of semiconductor cells according to embodiments of the second aspect, for the implementation of a neural network. The method comprises storing layer weights as the first operands of each of the semiconductor cells, and providing layer activations as the second operands of each of the semiconductor cells.

In a specific method according to embodiments of the present invention, for implementation of MLP, the first operands are weights that interconnect two MLP layers and the second operands are input-dependent activations.

In a specific method according to embodiments of the present invention, for implementation of CNN, the first operands are filters that are convolved with the second operands that are input-dependent activations.

A method according to embodiments of the present invention may use, for the implementation of the neural network, as arrays of semiconductor cells at least an input layer, an output layer, and at least one intermediate layer. The method may further comprise performing one or more algebraic operations to values of the at least one intermediate layer of the implemented NN; for instance including, but not limited to, normalization, pooling, and nonlinearity operations.

In a sixth aspect, the present invention provides a method of operating a neural network, implemented by at least one array of semiconductor cells according to embodiments of the second aspect of the present invention, wherein operating the neural network is done in a clocked regime, the XNOR or XOR operation within a semiconductor cell of the at least one array being completed within one or more clock cycles.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

## Brief description of the drawings

The invention will now be described further, by way of example, with reference to the accompanying drawings, in which:

FIG. 1 gives a schematic overview of a semiconductor cell according to embodiments of the present invention.

FIG. 2 illustrates a semiconductor cell according to embodiments of the present invention, that supports in-place XNOR operations;

FIG. 3 illustrates a semiconductor cell as in FIG. 2, with its sensing unit according to embodiments of the current invention;

FIG. 4 to FIG. 7 illustrate SPICE simulations of the semiconductor cell and sensing unit of FIG. 3 for all possible operand combinations, assuming that the memory unit is implemented with MRAM elements;

FIG. 8, FIG. 9 and FIG. 10 are schematic illustrations of a semiconductor cell according to embodiments off the present invention, implemented with a volatile memory unit, more particularly an SRAM unit, a latch and a flip-flop, respectively.

FIG. 11 illustrates an example of a plurality of arrays according to embodiments of the present invention, implementing reconfigurable NN hardware, containing memory cell macros and intermediate routing units (reconfigurable logic) in-between them, which facilitates the arithmetic operations, such as normalization and forwarding of activations;

FIG. 12 illustrates (part of) an array of semiconductor cells according to embodiments of the present invention, where the switch unit is implemented as vertical transistors, for instance VFETs, and wherein the memory elements are processed above the vertical transistors;

FIG. 13 illustrates (part of) an array of semiconductor cells according to embodiments of the present invention, where semiconductor cells are stacked on top of each other in a 3D fashion, with layers of the 3D structure comprising layers of arrays.

FIG. 14 illustrates an example of a directed graph between layers that are typically present in a MLP-type NN.

FIG. 15 illustrates an array of semiconductor cells according to embodiments of the present invention, implementing binary NN hardware, with layer control and arithmetic support in peripheral control units, such as allocation units and post-processing units.

FIG. 16 illustrates a method for writing semiconductor cells according to embodiments of the present invention, more particularly for storing values in the memory unit thereof, and for reading an XNOR output;

FIG. 17 illustrates a method for reading semiconductor cells according to embodiments of the present invention on a plurality of rows; and

FIG. 18 illustrates a method for reading semiconductor cells according to embodiments of the present invention on a plurality of columns.

FIG. 19 illustrates an overall view of a plurality of XNOR cells logically organized in rows and columns in an array, each array being provided with a sensing unit and a post-processing unit such as a logic unit for implementing at least one logical operation on at least one value read out of the array, a plurality of such arrays being connected to one another in a directed graph, in accordance with embodiments of the present invention.

- FIG. 20 illustrates a logic unit structure and data flow implementing normalization and signing operations of activation values, in accordance with embodiments of the present invention.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

**Detailed description of illustrative embodiments**

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, directional terminology such as top, bottom, front, back, leading, trailing, under, over and the like in the description and the claims is used for descriptive purposes with reference to the orientation of the drawings being described, and not necessarily for describing relative positions. Because components of embodiments of the present invention can be positioned in a number of different orientations, the directional terminology is used for purposes of illustration only, and is in no way intended to be limiting, unless otherwise indicated. It is, hence, to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being re-defined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

In embodiments of the present invention, semiconductor cells are logically organized in rows and columns. Throughout this description, the terms "horizontal" and "vertical" (related to the terms "row" and "column", respectively) are used to provide a co-ordinate system and for ease of explanation only. They do not need to, but may, refer to an actual physical direction of the device. Furthermore, the terms "column" and "row" are used to describe sets of array elements, in particular in the present invention semiconductor cells, which are linked together. The linking can be in the form of a Cartesian array of rows and columns; however, the present invention is not limited thereto. As will be understood by those skilled in the art, columns and rows can be easily interchanged and it is intended in this disclosure that these terms be interchangeable. Also, non-Cartesian arrays may be constructed and are included within the scope of the invention. Accordingly the terms "row" and "column" should be interpreted widely. To facilitate in this wide interpretation, the claims refer to logically organized in rows and columns. By this is meant that sets of semiconductor cells are linked together in a topologically linear intersecting manner; however, that the physical or topographical arrangement need not be so. For example, the rows may be circles and the columns radii of these circles and the circles and radii are described in this invention as "logically organized" rows and columns. Also, specific names of the various lines, e.g. word line and bit line, are intended to be generic names used to facilitate the explanation and to refer to a particular function and this specific choice of words is not intended to in any way limit the invention. It should be understood that all these terms are used only to facilitate a better understanding of the specific structure being described, and are in no way intended to limit the invention.

For the technical description of embodiments of the present invention, the design enablement of a multi-layer perceptron (MLP) with binary weights and activations is focused on. A similar description is valid, but not written out in detail, for convolutional neural networks (CNNs), with the appropriate reordering of logic units and the designation of the memory unit as storing binary filter values, instead of binary weight values.

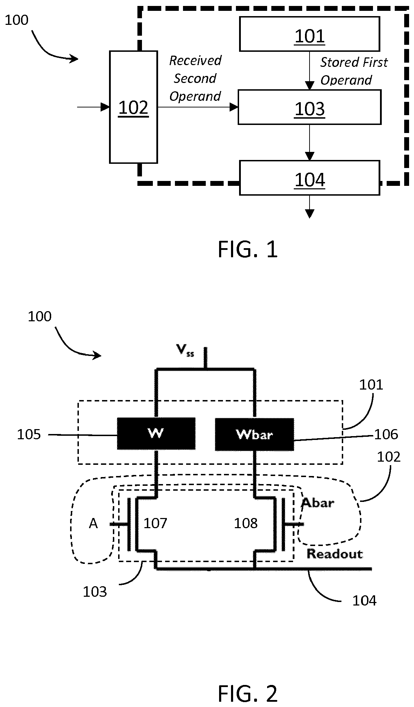

In a first aspect, the present invention relates to a semiconductor cell 100, as illustrated in FIG. 1, for performing an XNOR or XOR operation between a first and a second operand. The semiconductor cell 100 comprises a memory unit 101 for storing the first operand, and an input port unit 102 for receiving the second operand. The first operand is thus a constant value, which is stored in place in the semiconductor cell 100, more particularly in the memory unit 101 thereof. The second operand is a value fed to the semiconductor cell 100, which may be variable, and which may depend on the current input to the semiconductor cell 100, for instance a frame to be classified. The second operands are sometimes referred to as "activations". In particular embodiments of the present invention, where MLPs are involved, the first operand can be one of the weights that interconnect two MLP layers. In alternative embodiments, where CNNs are involved, the first operand can be one of the filters that are convolved with the input activations, or a weight of a final fully connected layer.

A semiconductor cell 100 according to embodiments of the present invention further comprises a switch unit 103 configured for implementing the XNOR or XOR operation on the stored first and second operand, and a readout port 104 for transferring an output of the XNOR or XOR operation.

The signal at the readout port 104 can be buffered and/or inverted to achieve the desired logic function (XOR instead of XOR, or vice versa, by inverting).

In embodiments of the present invention, the memory unit 101 can be a non-volatile memory unit, comprising one or more non-volatile memory elements, such as for instance, but not limited thereto, MTJ, MRAM, OXRAM, VMCO, PCM or CBRAM memory elements. In alternative embodiments, the memory unit 101 can be a volatile memory unit, comprising one or more volatile memory elements, such as for instance, but not limited thereto, MOS-type memory elements, e.g. CMOS-type memory elements.

FIG. 2 illustrates a first embodiment of a semiconductor cell 100 according to embodiments of the present invention, with a memory unit of the non-volatile type. The semiconductor cell 100 comprises a memory unit 101 for storing a first operand, an input port unit 102 for receiving a second operand, a switch unit 103 configured for implementing the logic XNOR or XOR operation on the stored first operand and the received second operand, and a readout port 104 for providing an output of the logic operation. The semiconductor cell 100 is designed to store a binary weight value W (as defined during NN training) and enables an in-place multiplication between this weight value W and an external binary activation A, thus implementing the XNOR operation. An XOR operation can be obtained by adding an inverter.

In the embodiment illustrated in FIG. 2, the memory unit 101 comprises a first memory element 105 for storing the first operand W, and a second memory element 106 for storing the complement Wbar of the first operand. In the embodiment illustrated, the memory elements may be nonvolatile memory elements, for instance binary non-volatile memory elements, such as memory elements based on Magnetic Tunnel Junctions (MTJs). Alternatively, rather than being binary, embodiments of the present invention may support multiple memory value levels. The version of the memory unit 101 illustrated in FIG. 2 comprises two MTJs, storing the complementary versions of the binary weight, namely W and Wbar. In alternative embodiments, only the weight W might be stored in the memory unit 101 of the semiconductor cell 100, and the complementary weight Wbar might be generated from the stored value.

The switch unit 103 is a logic component which, in the embodiment illustrated, comprises a first switch 107 for being controlled by the received second operand A, and a second switch 108 for being controlled by a complement Abar of the received second operand. Both the second operand A and the complement Abar may be received. Alternatively, the second operand A may be received, and the complement Abar may be generated therefrom. The second operand may be an external binary activation. The first and second switches 107, 108 may be transistors, for instance FETs. In particular embodiments, the switches may be vertical transistors, such as for instance vertical FETs. By means of the first and second switches 107, 108, each of the stored first operand and the complement of the stored first operand is switchably connected to a common node that is coupled to the readout port 104, 404. The input-dependent binary activation A and its complement Abar are assigned accordingly as voltage pulses of the transistor gate nodes. This implements the XOR or XNOR function.

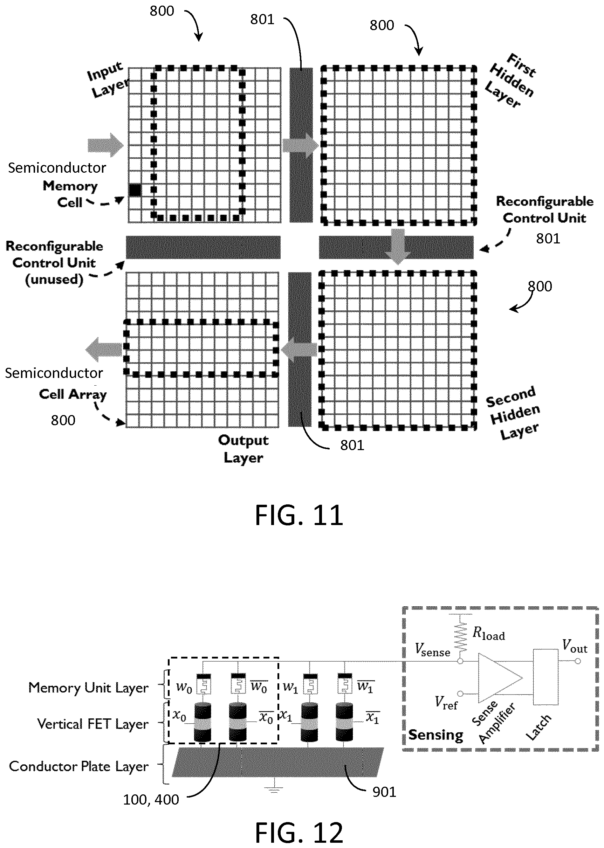

In particular embodiments, the first and second switches 107, 108 of the semiconductor cells 100, 400 may be vertical FETs. The memory elements 105, 106 may be processed above the vertical FETs, as illustrated in FIG. 12. This way, each semiconductor cell 100 may comprise a plurality of sub-devices, e.g. a memory unit 101 and a switch unit 103, which are physically laid out one on top of the other. Corresponding sub-devices of similar cells 100 in an array may be designed to be laid in a single layer, such that a memory unit layer of an array comprises the memory units 101 of semiconductor cells 100 in the array, while a switch unit layer of an array comprises the switch units 103 of the semiconductor cells in the array. The plurality of semiconductor cells 100 in the array may be electrically connected to one another by means of conductive, e.g. metallic, traces.

The first and second switches 107, 108 may be n-type transistors, of which the sources may be connected to a conductive plane 901 that is grounded, as illustrated in FIG. 12. Alternatively, the first and second switches 107, 108 may be p-type transistors, and the switches may be referred to VDD. Yet alternatively, the first and second switches 107, 108 may be transmission gates, and the switches may be referred to any logic level.

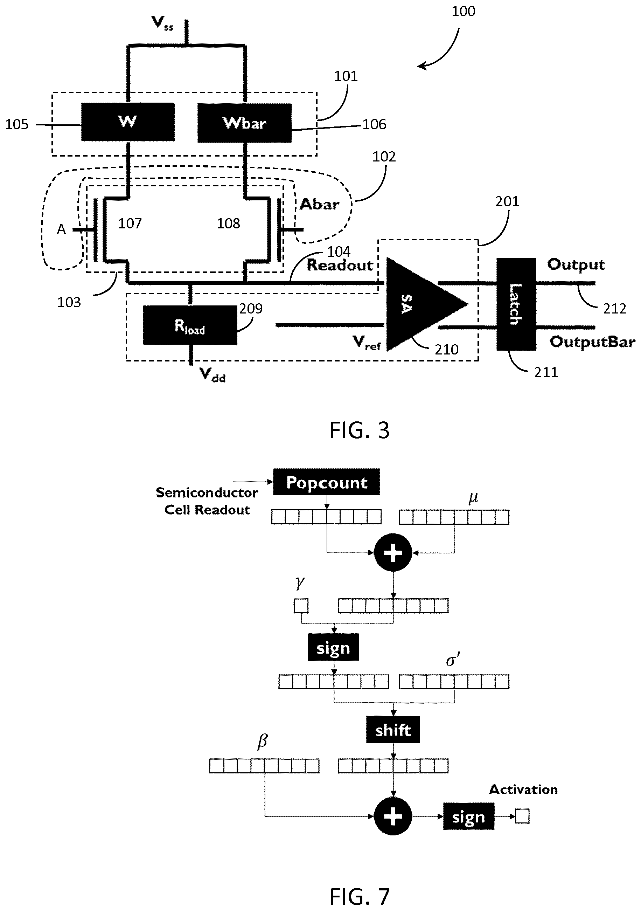

Using a sense unit 201, as illustrated in FIG. 3, a signal at the readout port 104 can be read out. This signal is representative for the XNOR value of the weight W and the activation A (W XNOR A). This signal can be an electrical signal such as a current signal or a voltage signal.

In particular embodiments, the signal is a current signal, and a load resistance 209 may be used to enable readout of the XNOR signal as a voltage signal. This voltage can be measured at readout port 104, and it can be sensed in any suitable way, for instance by using a sense amplifier 210, the output of which can be latched by any suitable latch element 211 to a final output node 212. The load resistance 209 can be any suitable type of resistance, such as for instance a pull-up resistance, a pull-down resistance, an active resistor, a passive resistor.

Alternatively, rather than a voltage, a current can be measured at the readout port 104, which can be sensed in any suitable way, for instance by using a transimpedance amplifier. The current signal at the readout port 104 can be brought to a final output node 212. It can be converted into a voltage signal.

It is an advantage of embodiments of the present invention that a "wired OR" operation is present in the non-volatile implementation of the semiconductor cells according to the present invention. For instance in the non-volatile memory case as in FIG. 2, a wired or is performed between the two non-volatile memory elements 105, 106, whereby according to the second operand A, Abar (pulsing the switch unit 103 - in a particular case for instance the two nFETs 107, 108), the wired or is dictated by the current flowing from either of the two non-volatile memory elements 105, 106.

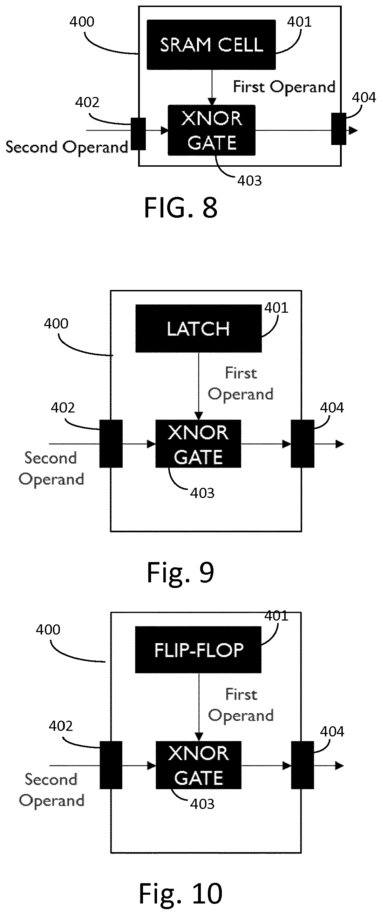

In other embodiments, as illustrated in FIG. 8, FIG. 9 and FIG. 10, a semiconductor cell 400 comprises a memory unit 401 of the volatile type, e.g. an SRAM cell, a latch or a flip-flop, respectively, for storing a first operand, an input port unit 402 for receiving a second operand, a switch unit configured for implementing a logic XNOR or XOR operation on the stored first operand and the received second operand, for instance an XNOR gate 403, and a readout port 404 for providing an output of the logic operation. Advantageously, a memory unit 401 of the volatile type may be MOS based, for instance CMOS based.

Semiconductor cells 100, 400 according to embodiments of the present invention can be used in the implementation of a neural network (NN). Hereto, the semiconductor cells 100, 400 are organized in an array, in which they are logically organized in rows and columns. The array may comprise word lines and bit lines, wherein the word lines are for instance running horizontally, and are configured for delivering second operands to input ports of the semiconductor cells, and wherein the bit lines are for instance running vertically, and are configured for receiving the outputs of the XNOR or XOR operations from the output ports. Preferably, the array may comprise more than one column and more than on row of semiconductor cells.

It is an advantage of an array of semiconductor cells according to embodiments of the present invention that it reduces energy requirements of classification operations, by letting input-dependent values (NN activations) flow through arrays of pre-trained binary weights, with arithmetic operations performed as close to their operands as possible.

A sense unit 201, for instance comprising a load resistance 209, may be provided in each semiconductor cell 100, 400 for readout of the logic operation implemented in the cell. Alternatively, not illustrated in the drawings, a sense unit, for instance comprising a load resistance, may be shared between a number of semiconductor cells 100 defined at design time (e.g., but not limited thereto, among all cells in a column).

The signal, e.g. current or voltage, at the readout port 104 can be sensed using a sense amplifier 201, such as for instance, but not limited thereto, the one featured in S. Cosemans, W. Dehaene and F. Catthoor, "A 3.6pJ/access 480MHz, 128Kbit on-Chip SRAM with 850MHz boost mode in 90nm CMOS with tunable sense amplifiers to cope with variability," in Solid-State Circuits Conference, 2008. ESSCIRC 2008. 34th European, 2008. A representative schematic is illustrated in FIG. 3 for the implementation with a non-volatile memory unit. Similarly, a sensing unit as illustrated in FIG. 3 may be implemented in case of a semiconductor cell with a volatile memory unit.

Generally, sensing units 201 may be shared among multiple semiconductor cells 100. For instance, in a typical memory, multiple columns are using the same sense amplifier. This can be configured at design time, based on the semiconductor cell array dimensions.

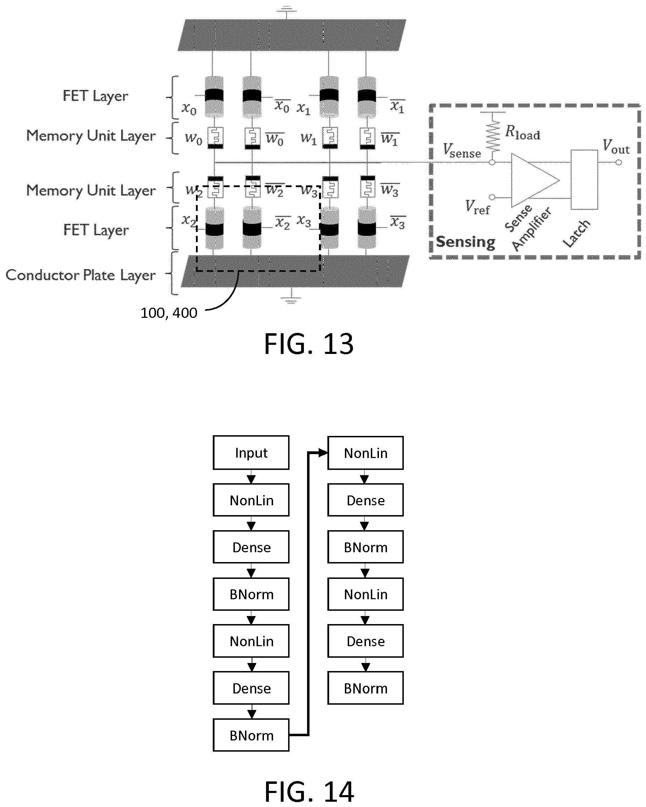

In particular embodiments of an array of the present invention, as illustrated in FIG. 13, semiconductor cells 100, 400 may be physically stacked on top of each other in a 3D fashion, with layers of the 3D structure comprising layers of arrays of semiconductor cells according to embodiments of the present invention. In the embodiment illustrated in FIG. 13, the switch units comprise vertical transistors, for instance vertical FETs, but this embodiment of the invention is not limited to this implementation. In general, arrays of semiconductor cells according to embodiments of the present invention may be stacked in a 3D fashion, wherein each semiconductor cell comprises a memory unit, an input port, a switch unit and a readout port.

The semiconductor cells of each array In each array in the 3D structure comprise memory units which may be laid out in a memory unit layer, and switch units which may be laid out in a switch layer, in particular embodiments a FET layer. The sequence of layers in a 3D structure can be, but does not need to be, as illustrated in FIG. 13.

As an example, a binarized neural network (BNN) software implementation (Courbariaux et al. CoRR 2016 - https://arxiv.org/abs/1602.02830) is considered. Multiplication between a binary activation x and a binary weight w on the cell of FIG. 3 is described, with its logic description as in the Table below. The non-volatile memory elements 105, 106 in the embodiment discussed are MTJs.

Table 1 - Truth table of the semiconductor cell 100 of FIG. 3

| w (wbar being the complement) | | | | x (xbar being the complement) | | |
|---|---|---|---|---|---|---|
| numerical | Logical | Resistance | Magnetisation | numerical | Logical | Full swing |
| -1 | 0 | $R_{LRS}$ | 0 | -1 | 0 | $V_{ss}$ |
| -1 | 0 | $R_{LRS}$ | 0 | +1 | 1 | $V_{dd}$ |
| +1 | 1 | $R_{HRS}$ | $\pi$ | -1 | 0 | $V_{ss}$ |
| +1 | 1 | $R_{HRS}$ | $\pi$ | +1 | 1 | $V_{dd}$ |
| w X x | | $V_{sense}$ | $V_{out}$ | Waveform | | |
| numerical | Logical | Half swing | Full Swing | Figure | | |
| +1 | 1 | $V_H$ | $V_{dd}$ | 4 | | |
| -1 | 0 | $V_L$ | VSS | 5 | | |
| -1 | 0 | $V_L$ | $V_{ss}$ | 6 | | |
| +1 | 1 | $V_H$ | $V_{dd}$ | 7 | | |

The semiconductor cell 100 suitable for implementing a binary multiplication leverages the equivalence between the numerical values of the BNN software assumptions as in the Courbariaux paper mentioned above (-1/+1), the logical values of digital logic (0/1), the resistance values of the MTJs (Low Resistive State - LRS / High Resistive State - HRS) and the angle of the (out-of-plane) magnetization of the MTJ's free layer. The two MTJs 105, 106 of the cell 100 hold the binary weight value w and its complement $\overline{w}$. The gate nodes of the two nFETs '107, 108 are pulsed according to the activation value x and its complement $\overline{x}$. The XNOR (or multiplication) output appears at the output port 104 of the voltage divider as a half-swing readout voltage, and is indicated as $V_{sense}$ in the table above. In order for the latter value to be used in further digital logic, it has to be sensed and translated to an equivalent full-swing voltage. This is a requirement that already exists in MRAM (and generally in embedded memory) arrays and that can be met using a simple sense amplifier 210. As such, the provision of a reference voltage $V_{ref}$ is required, so that the sense amplifier 210 can distinguish the two possible levels of the readout value $V_{sense}$ that can be measured at the readout port 104. A latch 211 is placed after the sense amplifier 210 to store the read-out value, for instance for further sampling by digital logic.

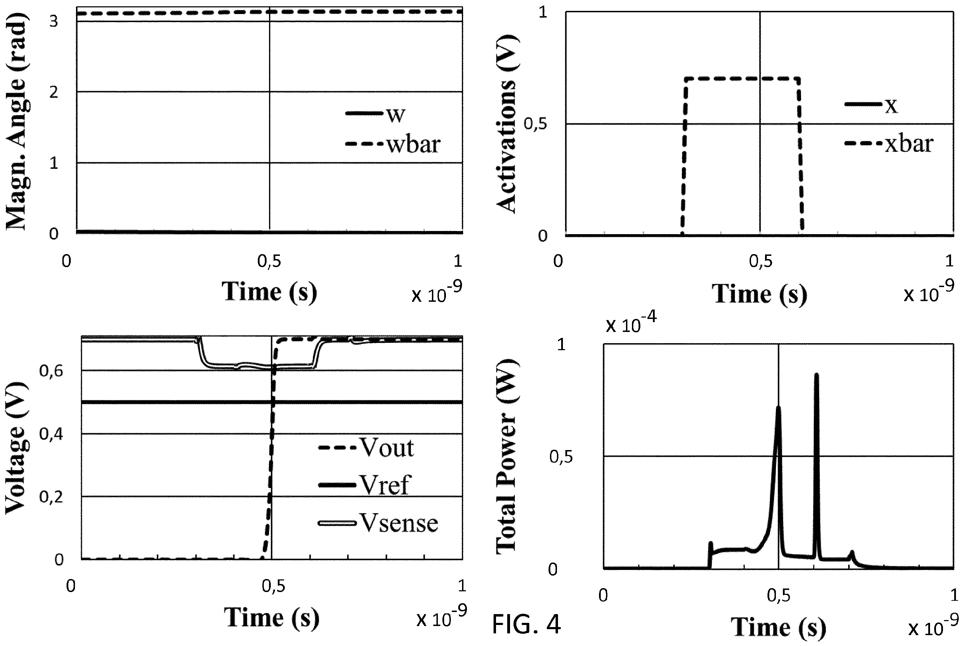

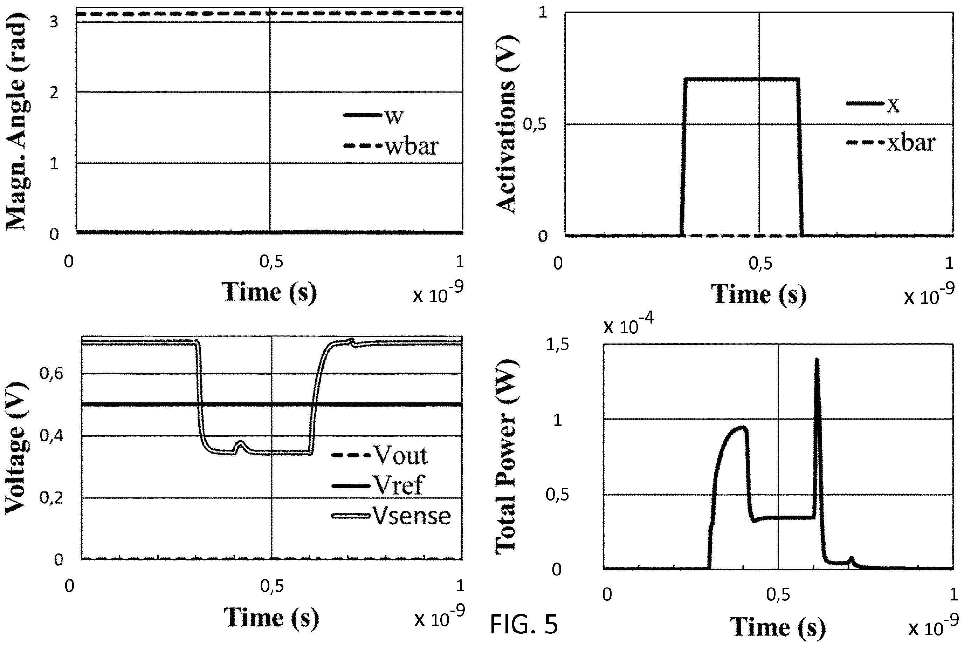

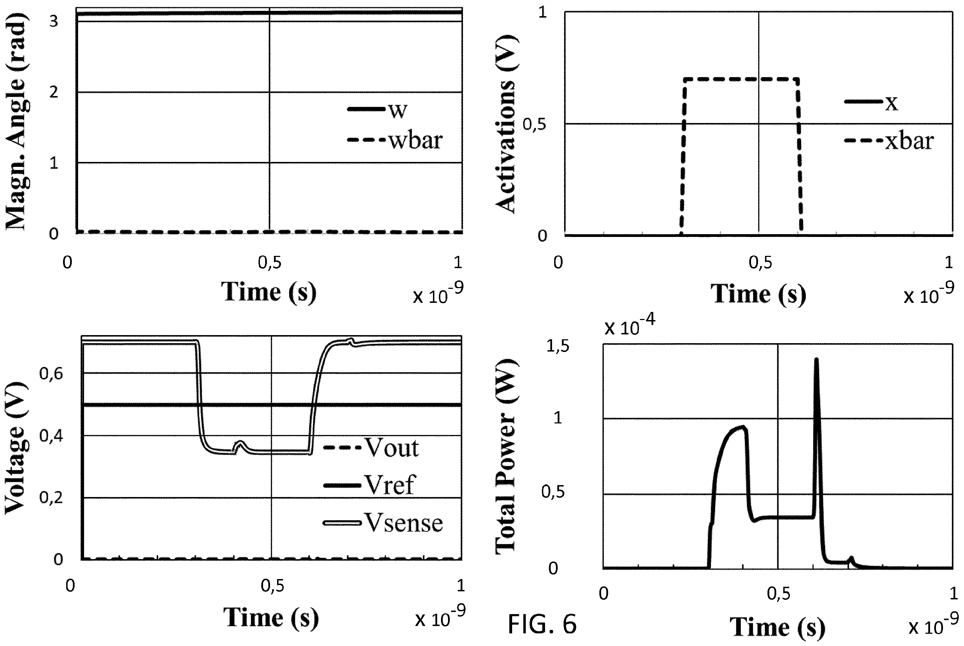

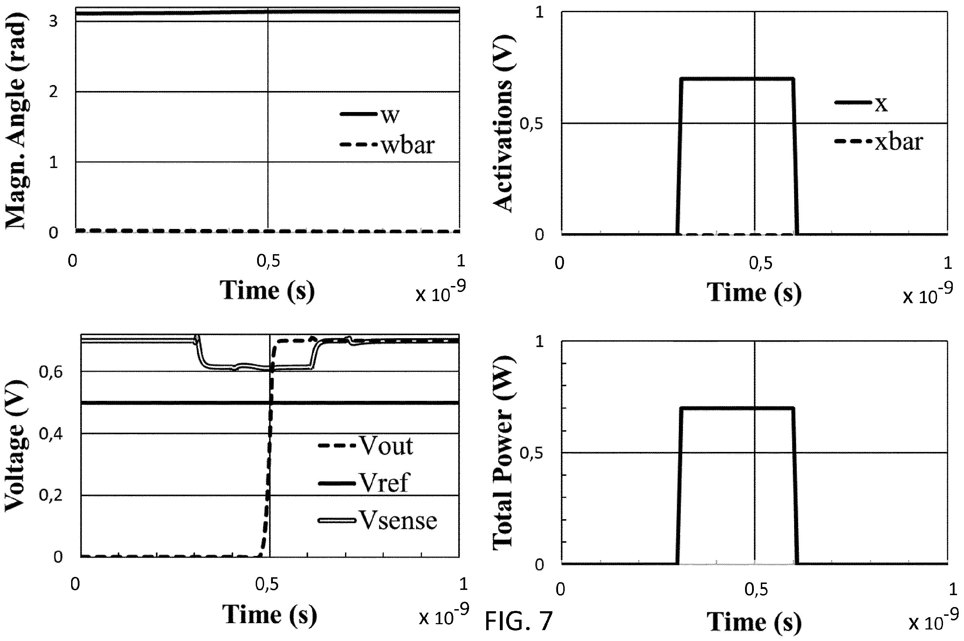

The respective SPICE simulation output can be seen in FIG. 4 to FIG. 7, as indicated in the last column of Table 1.

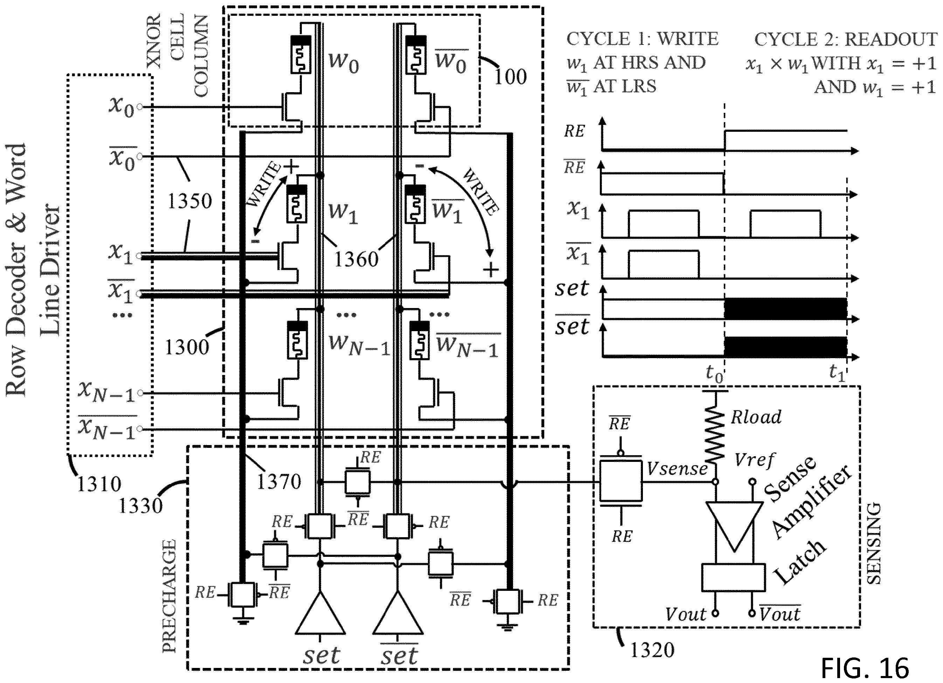

FIG. 16 contains an indicative schematic for an arrangement of XNOR cells 100 arranged in a column 1300, along with units needed for writing weights and reading XNOR outputs. For brevity, only a single column 1300 of N (3 in the embodiment illustrated) XNOR cells 100 is shown. Activation signals $x_i$ and $\overline{x}_1$, (gate voltages for each XNOR cell 100, applied to word lines 1350 - active word lines being indicated in bold) are connected to a row decoder 1310, following the traditional word-line design paradigm. Similarly, full-swing reading of the XNOR output is done in the sensing unit 1320. For writing the weights in the memory elements of the XNOR cells 100, in the embodiment illustrated the STT-MRAMs, the top and bottom electrodes of each STT-MRAM are pulled out of the column 1300 to the precharger 1330. Below, two cycles of operation are described: configuration of weight $w_1$ to +1 (along $\overline{w}_1$ to -1) and its subsequent multiplication with +1 (the in-place multiplication taking place in the cell 100 in accordance with embodiments of the present invention).

- Cycle 1 (Weight Configuration): When $w_1$ needs to be set to +1, MTJ $w_1$ needs to be configured to HRS (high resistive state) and MTJ $\overline{w}_1$ needs to be configured to LRS (low resistive state). For this to happen, the read enable signals need to be set accordingly to $RE = 0$, $\overline{RE} = 1$ so that the top electrodes of the MTJs, connected to the read bitlines 1360, are disconnected from the sensing circuit 1320. Then, biases are set ($set = 1$ and $\overline{set} = 0$) so that proper polarity can be applied to the target MTJs for writing. Then, both $x_1$ and $\overline{x}_1$ need to be pulsed so that the resistance of the two corresponding MTJs can be configured. The latter is performed by current flowing from the precharge unit 1330, through the write bit lines 1370, the MTJs and the pulsed nFETs.

- Cycle 2 ($x_1$ XNOR $\overline{w}_1$ Readout, assuming $x_1 = +1$):} With the weight properly configured in the two MTJs of the cell 100, the multiplication is read out by setting the enable signals accordingly ($RE = 1$, $\overline{RE} = 0$ - this connects the top electrodes of the MTJs to the sensing unit via the read bit lines 1360) and pulsing the activation values in a complementary way ($x_1 = 1$, $\overline{x}_1$, = 0). According to the truth table provided, the expected output is $V_{out} = V_{dd}$.

From the above example, it can be seen how the XNOR cell 100 can operate within the well-established memory design requirements. It should be noted that the complementarity of activation signals $x_1$ and $\overline{x}_1$ is only applicable when reading from the array. When NVMs are written, these signals are actuated pulsed as traditional word lines. Finally, to enable writability of both resistive states, (requiring drive for both positive and negative biasing of the STT-MRAM), the nFETs of the semiconductor cell could be replaced with transmission gates, given that both $x$ and $\overline{x}$ are routed to each cell.

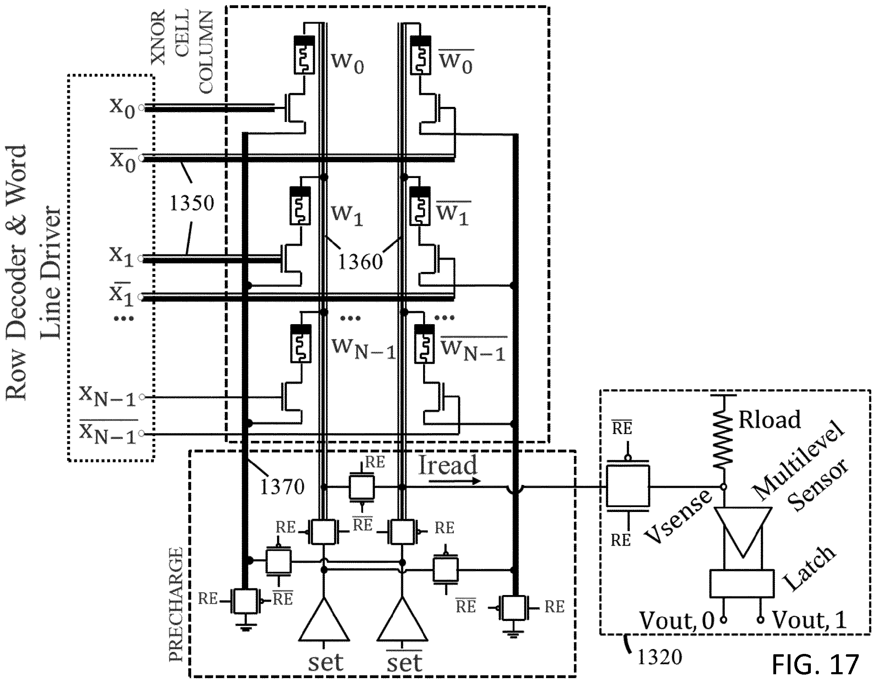

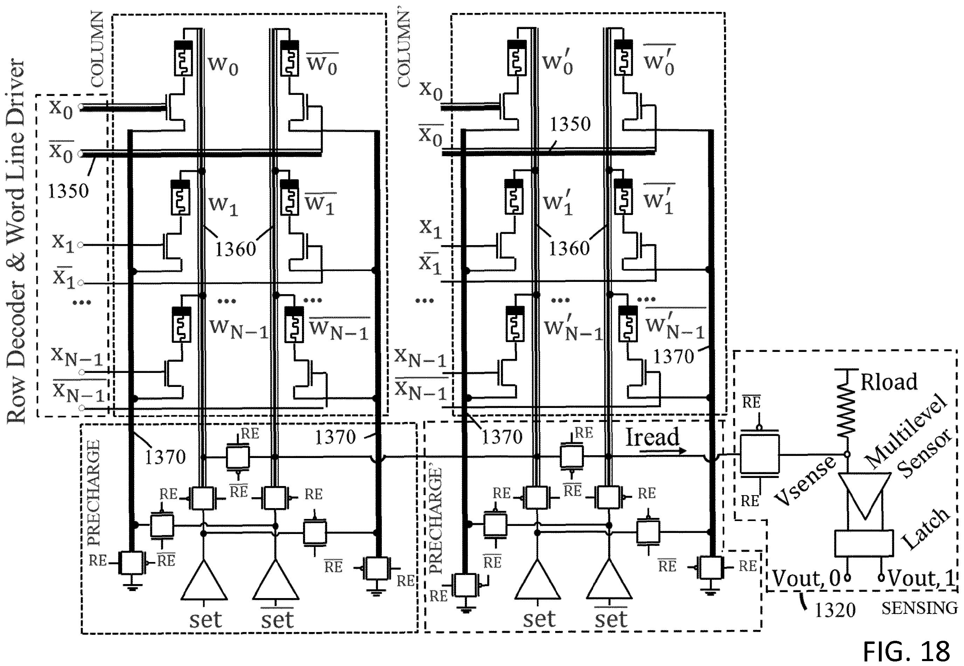

With proper signaling of word lines 1350, it is possible to route multiple readout values (from more than 1 read semiconductor cells) to the sense unit 1320, which should be designed to distinguish between the applicable input combinations. In FIG. 17 an operation similar to Cycle 2 above is performed, with the difference that both cells 0 and 1 (active word lines being indicated in bold) contribute with their XNOR output in the read current that goes to the sense unit 1320. In this case, the latter should be configured so that it can sense all combinations of readout values from the two cells. This can be achieved in many ways, such as (but not limited to) by using different references for the sensed quantity (e.g. multiple current references), in order to distinguish the different $I_{read}$ combinations from the two sensed XNOR outputs (originating from the two enabled semiconductor cells). This is means that the output of the multi-level sensor should also support multiple values, which in FIG. 17 is shown with two output bits ($V_{out,0}$ and $V_{out,1}$). As long as the multiple output values are distinguishable, they can be sensed. In FIG. 18, a similar read scenario is shown, whereby cells from different columns are activated (active word lines being indicated in bold) for XNOR readout, their output currents being routed to the same sense unit 1320 (which should be able to distinguish between all applicable combinations of readout values originating from the activated cells). Sensing of the multiple $I_{read}$ values can be achieved in a way similar (but not limited to) the one described for FIG. 17.

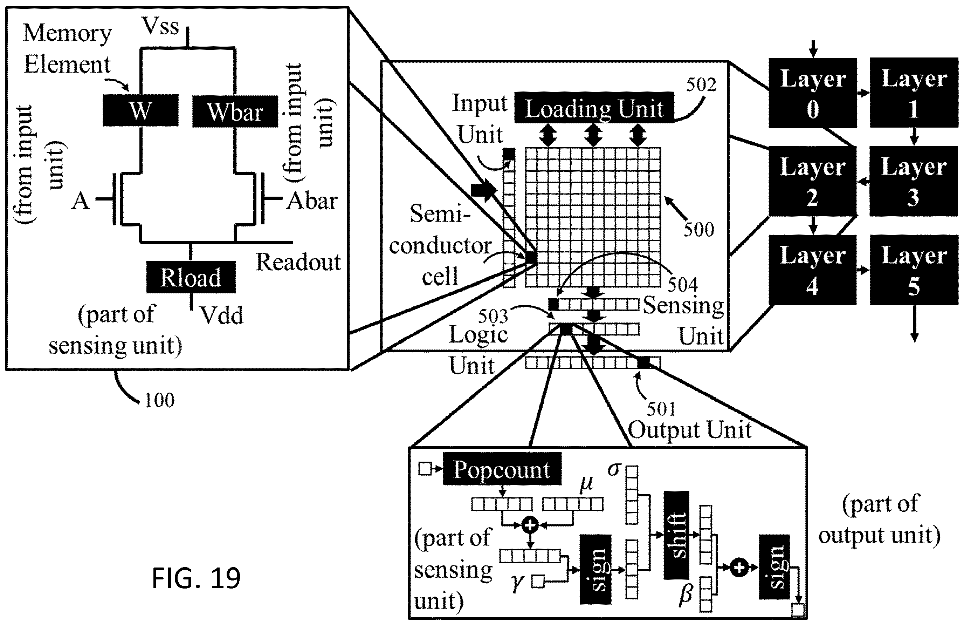

A NN-style classifier has a wide range of operands that remain constant during inference (classification). It is hence an advantage of semiconductor cells 100, 400 according to embodiments of the present invention, and more in particular of such semiconductor cells 100, 400 arranged in an array 500, that such operands can be stored locally (in the memory unit 101, 401), while input-dependent activations can be routed to specific points of the classifier implementation, where computation takes place. Additionally, novel algorithmic flavors of NN-style classifiers are based on binary weights/filters and activations, further reducing the memory requirements of a software classifier implementation. In accordance with this trend, embodiments of the present invention propose in-place operations for the dot-product stages of a classifier and post-processing units, such as for instance simple logic, to interconnect between classifier layers with simple math operations, as graphically illustrated in FIG. 19. In particular embodiments of this concept, non-volatile memory elements (such as for instance MTJ, MRAM, OXRAM, VMCO, PCM or CBRAM cells) may be used as building blocks of such a layer memory units, to store the constant operands that are used at various layers of the classifier. In particular embodiments, the non-volatile memory unit may comprise non-volatile memory elements each supporting multi-level readout. In particular embodiments, the non-volatile memory elements may each support multiple resistance levels. If the memory unit supports multiple resistance levels, the XNOR/XOR readout can also be mutli-level, hence allowing to encode scalar (non-binary) weight/output values.

In other embodiments, a traditional latching circuit may be used. In other embodiments, the dot-product layers can be mapped on an array of memory elements, whereby the control of each layer and any required mathematical operation is implemented outside the array in dedicated control units. In particular uses of a system according to embodiments of the present invention, dot-product layers can be used to implement partial products of an extended mathematical operation, the partial products being reconciled in the peripheral control units of the memory element array.

An idea is to use the current system during inference, with weights and hyperparameters (such as $\mu$, $\gamma$, $\sigma'$, and $\beta$) fixed after an offline training session. In the implementation illustrated in FIG. 19, a loading unit 502 is provided for receiving pre-trained values from an outside source (e.g. the memory hierarchy of GPU workstation that actually performs the neural network).

The basic advantage of an implementation such as the above is that each semiconductor cell 100, 400 according to embodiments of the present invention in a column produces the addends of the dot-product, namely all individual binary multiplications. Assuming that binary weights and activations are of values +1 and -1, and given their logical mapping to 1 and 0, the dot-product requires a popcount of the +1 (1 in logic) values across the semiconductor cells that contribute to the dot product. This will result to an integer value, which is the scalar activation of the respective neural network neuron. In these classifiers, neuron inputs are generally normalized and pass through a final nonlinearity (computing a non-linear activation function f(x), where x is the sum of XNOR operations of one or more columns of the array of cells) before being forwarded to the next layer of the neural network (either MLP or CNN). Examples of non-linear functions used in machine learning are, without being limited thereto, sigmoid, tanh, Rectified Linear Unit (ReLU), and others.

A logic unit according to embodiments of the present invention may implement the normalization, using trained parameters $\mu$, $\gamma$, $\sigma'$, and $\beta$. Generally, the operation applied to the popcount output is of a double precision type and actually implements the following calculation, where x is the dot-product output:

$$y = \frac{x - \mu}{\sigma'}\gamma + \beta$$

In accordance with embodiments of the present invention, the following data type refinements may be implemented in order to reduce the complexity of the logic units that stand between neural network layers. These are organized according to FIG. 19

1. Values $\mu$ and $\beta$ may be stored in an integer format, so that the respective addition operations are aggressively simplified.
2. Multiplication by $\gamma$ may be replaced with a simple sign extension of the scalar operand, so that only the sign of parameter $\gamma$ needs to be available during inference.
3. Division by $\sigma$ may be replaced by a shift operation (equivalent of dividing by the nearest power of two).

As such, this approach aims at optimizing the inference using NNs (MLPs or CNNs), assuming pre-trained binary weights and hyperparameters. That way, NN classification models can be deployed on the field in low energy and state-of-the-art performance with the option of non-volatile storage of trained weights and hyperparameters, thus enabling rapid reboot times of the respective NN classification hardware modules.

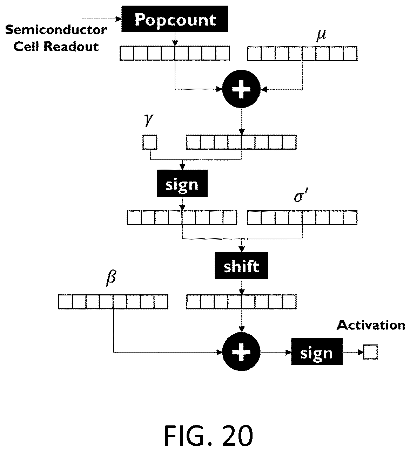

The above technical description details a hardware implementation of an MLP, using binary NVM memory elements in memory units that locally perform an XNOR operation between the stored binary weight and a binary activation input. These XNOR outputs are then sensed by a sensing unit 504 and routed to a logic unit 503, where they are counted at the bottom of each row. In an implementation as illustrated in FIG. 20, the sum is normalized and then signed again (binarized, e.g. assigned 1 in case it is positive or 0 in case it is negative) and this value can be passed as an input-dependent binary activation at the next layer of the neural network implementation (i.e. assigned to the output unit 501 according to FIG. 19).

The same building blocks, namely the dot-product engine and post-processing units like the logic units performing simple arithmetic operations like normalization and binarization nonlinearity can be extended or rearranged to create CNN building blocks. These include dot-product kernels (to perform convolution between input activations and filters), batch normalization, pooling (which is effectively an aggregation operation) and binarization

One way to organize the layers of the dot-product arrays and the interleaving logic is the meandric layout view of FIG. 19 or FIG. 14 (directed graph). In such directed graph, dense layers implement the all-to-all connection between semiconductor

cells of a previous layer to semiconductor layers of a next layer. They implement the dot-product $y_k = \sum_{j=0}^{N-1} x_j w_{kj}$. This involves having fixed sizes of the dot-product arrays 500 (and the interconnecting logic 503) and use them to allocate the NN implementation that is required by the classification problem. This is a rigid setup, given the fixed size of the semiconductor cell arrays 500, and only requires the loading of weights into the memory units 101, 401 to initialize an NN inference execution.

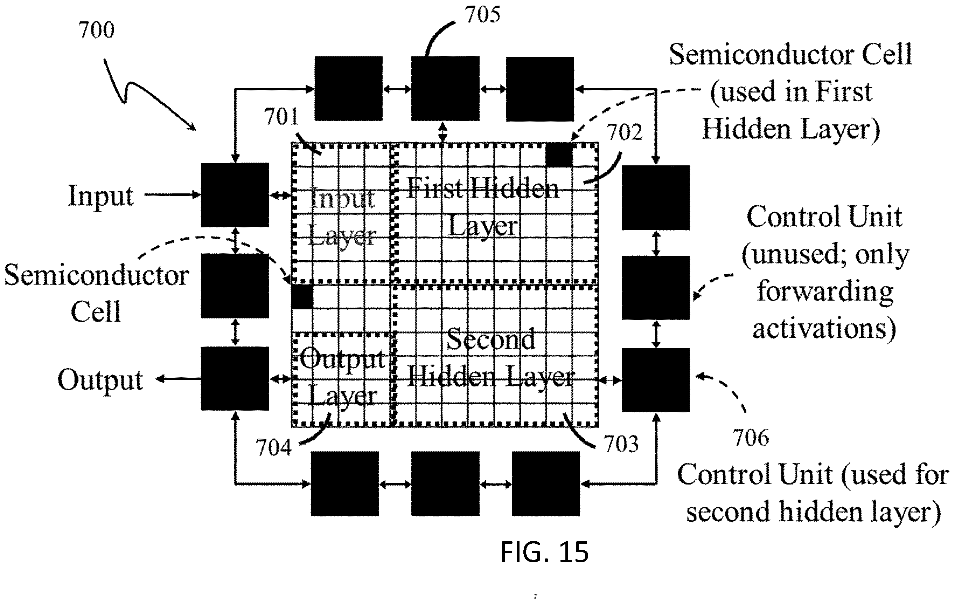

An alternative to this solution is a single, big array 700 of semiconductor cells according to embodiments of the present invention that enable in-place binary products. On this large area, different sizes of dot-product layers are allocated and any layer interconnection, along with the associated normalization logic is implemented in peripheral controllers. An illustrative view of this arrangement can be seen in FIG. 15, which is a system-level view of a binary NN hardware implementation with layer control and arithmetic support in peripheral control units, including allocation units, which are interconnected for activation value forwarding. For the sake of simplicity, an implementation with one input layer 701, one output layer 704 and a first hidden layer 702 and a second hidden layer 703, connected in a directed graph, is illustrated.

Binary weights that connect neuron layers of the entire NN are allocated on different regions of a big semiconductor cell array 700 and dot-product output is aggregated on associated control units 705, 706 that are situated in the periphery of the semiconductor cell array 700. These units 705, 706 additionally perform normalization and forward the activations to the next NN layer, namely the respective peripheral control unit.

Still alternatively, a hybrid solution between an embodiment with a meandric layout, as for example illustrated for one implementation in FIG. 19, and an embodiment with a single big array of semiconductor cells on which different sizes of dot product layers are allocated, as for example illustrated for one implementation in FIG. 15, involves reconfigurable control units 801 implemented on the right and left of semiconductor cell arrays 800. The idea borrows the meandric layout style from FIG. 19, by enabling reconfigurable connection between NN layers through the reconfigurable control units 801 that are placed in-between the memory cell arrays 800. The reconfigurable logic 801 inbetween the semiconductor cell arrays 800 facilitates arithmetic operations, such as normalization and forwarding of activations. Depending on the size of the input and the number of neurons per layer, a different portion of the semiconductor cell array 800 is used in each case. For the sake of simplicity, four semiconductor cell arrays 800, one for the input layer, one for a first hidden layer, one for a second hidden layer and one for the output layer, are illustrated in FIG. 11.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

**Claims**

1. A semiconductor cell (100, 400) for performing a logic XNOR or XOR operation, the semiconductor cell (100, 400) comprising:

   a memory unit (101, 401) for storing a first operand,
   an input port unit (102, 402) for receiving a second operand,
   a switch unit (103 403) configured for implementing the logic XNOR or XOR operation on the stored first operand and the received second operand, and
   a readout port (104, 404) for providing an output of the logic operation.

2. A semiconductor cell (100, 400) according to claim 1, wherein the switch unit (103) is arranged for being provided with both the stored first operand and a complement of the stored first operand and further with the received second operand and a complement of the received second operand to perform the logic operation wherein the memory unit optionally comprises a first memory element (105) and a second memory element (106), for storing the first operand and for storing the complement of the first operand, respectively.

3. A semiconductor cell (100, 400) according to claim 2, wherein the switch unit comprises a first switch (107) and a second switch (108) for being controlled by the received second operand and the complement of the received second operand, respectively, and wherein each of the stored first operand and the complement of the stored first operand is switchably connected through one of the first or second switch (107, 108) to a common node that is coupled to the readout port (104, 404).

4. A semiconductor cell (100, 400) according to any of the previous claims, wherein the memory unit is a non-volatile memory unit, the non-volatile memory unit optionally comprising non-volatile memory elements supporting multi-level readout.

5. A semiconductor cell (100, 400) according to any of the previous claims, wherein the switch unit is implemented using vertical transistors which have the channel perpendicular to the wafer substrate.

6. An array of cells logically organized in rows and columns, wherein the cells are semiconductor cells according to any of claims 1 to 5.

7. An array according to claim 6, the array furthermore comprising word lines and read bit lines, wherein the word lines are configured for delivering second operands to input ports of the semiconductor cells, and wherein the read bit lines are configured for receiving the outputs of the XNOR or XOR operations from the readout ports of the cells in the array connected to that read bit line; and/or the array furthermore comprising a sensing unit shared between different cells of the array; and/or the array furthermore comprising a pre-processing unit for creating the second operand for at least one of the semiconductor cells in the array; and/or the array furthermore comprising allocation units for allocating subsets of the array to nodes of a directed graph.

8. An array according to any of claims 6 or 7, wherein the readout port of at least one semiconductor cell from at least one row and at least one column of the array is read by at least one sensing unit configured to distinguish between at least two levels of a readout signal at the readout port of the at least one read semiconductor cell, the array furthermore optionally comprising at least one post-processing unit, for implementing at least one logical operation on at least one value read out of the array.

9. A set comprising a plurality of arrays according to any of claims 6 to 8, wherein the arrays are connected to one another in a directed graph.

10. A set according to claim 9, the arrays being statically connected according to a directed graph, or the set furthermore comprising intermediate routing units (801) for reconfiguring connectivity between the arrays (800).

11. A 3D-array comprising at least two arrays according to any of claims 6 to 8, wherein the semiconductor cells of respective arrays are physically stacked in layers one on top of the other.

12. A method of using at least one array of semiconductor cells according to any of claims 6 to 8 for the implementation of a neural network, the method comprising storing layer weights as the first operands of each of the semiconductor cells, and providing layer activations as the second operands of each of the semiconductor cells.

13. A method according to claim 12, for implementation of MLP, wherein the first operands are weights that interconnect two MLP layers and the second operands are input-dependent activations, or for implementation of CNN, wherein the first operands are filters that are convolved with the second operands that are input-dependent activations.

14. A method according to any of claims 12 or 13, the method using, for the implementation of the neural network, as arrays of semiconductor cells at least an input layer, an output layer, and at least one intermediate layer, the method further comprising performing algebraic operations to values of the at least one intermediate layer of the implemented NN.

15. A method of operating a neural network, implemented by at least one array of semiconductor cells (100, 400) according to any of claims 8 to 14, wherein operating the neural network is done in a clocked regime, the XNOR or XOR operation within a semiconductor cell (100, 400) of the at least one array being completed within one or more clock cycles.

100

101

102    Received
        Second
        Operand

        Stored First
        Operand

103

104

FIG. 1

100

V$_{ss}$

101

105 ──── W        Wbar ──── 106

102

A      107    108    Abar

Readout

103                    104

FIG. 2

FIG. 3

FIG. 7

FIG. 4

FIG. 5

FIG. 6

FIG. 7

EP 3 373 304 A2

400
401
SRAM CELL

First Operand

402
Second Operand

XNOR
GATE

404

403

FIG. 8

401
LATCH

400

First
Operand

402
Second
Operand

XNOR
GATE

404

403

Fig. 9

401
FLIP-FLOP

400

First
Operand

402
Second
Operand

XNOR
GATE

404

403

Fig. 10

FIG. 11

FIG. 12

FIG. 13

FIG. 14

FIG. 15

FIG. 16

FIG. 17

FIG. 18

FIG. 19

EP 3 373 304 A2

FIG. 20

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **S. COSEMANS ; W. DEHAENE ; F. CATTHOOR.** A 3.6pJ/access 480MHz, 128Kbit on-Chip SRAM with 850MHz boost mode in 90nm CMOS with tunable sense amplifiers to cope with variability. *Solid-State Circuits Conference, 2008. ESSCIRC 2008. 34th European,* 2008

- **COURBARIAUX et al.** *CoRR,* 2016, https://arxiv.org/abs/1602.02830